# EUROPÄISCHE PATENTSCHRIFT

(11) **EP 0 696 741 B1**
(45) Veröffentlichungstag und Bekanntmachung des Hinweises auf die Patenterteilung: **02.10.2002**
(21) Anmeldenummer: 95110932.1
(22) Anmeldetag: 12.07.1995
(51) Int. Cl.: G01R 29/08, H04B 7/005

(54) **Bipolare kaskadierbare Schaltungsanordnung zur Signalbegrenzung und Feldstärkedetektion**
Bipolar cascadable circuit for signal limiting and field strength detection
Circuit cascadable bipolaire pour limiter le signal et détection de champs

(30) Priorität: 08.08.1994 DE 4427974
(43) Veröffentlichungstag der Anmeldung: 14.02.1996
(73) Patentinhaber: Infineon Technologies AG, 81669 München (DE)
(72) Erfinder: Thomas, Volker, Dr. Ing., D-81245 München (DE)
(74) Vertreter: Epping Hermann & Fischer

(56) Entgegenhaltungen:
- EP-A- 0 538 806
- EP-A- 0 541 226
- EP-A- 0 599 399
- US-A- 4 578 820
- PATENT ABSTRACTS OF JAPAN vol. 016, no. 134 (E-1185), 6.April 1992 & JP 03 295305 A (MITSUBISHI ELECTRIC CORP), 26.Dezember 1991,

## Beschreibung

Die Erfindung betrifft eine bipolare kaskadierbare Schaltungsanordnung zur Signalbegrenzung und Feldstärkedetektion mit einer Begrenzerstufe, die ein Ausgangssignal erzeugt, das einer Detektionsstufe zugeführt wird, wobei die Detektionsstufe stromgespeist wird und diese Stromspeisung und damit das Ausgangssignal der Detektionsstufe abhängig von der Versorgungsspannung ist.

Eine derartige Schaltungsanordnung ist beispielsweise bei J.Fenk, B.Birth, R.G.Irvine, P.Sehrig, K.R.Schön "An RF-Front End For Digital Mobil Radio", IEEE 1990, Bipolar Circuits and Technology Meeting 11.2, beschrieben. Derartige Schaltungen sind kaskadierbar, in diesem Fall sieben Stufen, wodurch eine Empfangsschaltung realisiert wird, wie sie in der Rundfunk- und Fernsehtechnik sowie der Mobilfunktechnik häufig benötigt wird. Dazu werden die Begrenzerverstärkerstufen hintereinander geschaltet, während die den einzelnen Begrenzerverstärkerstufen jeweils zugeordneten Feldstärkedetektorstufen ausgangsseitig parallel geschaltet werden.

Bei drahtlosen Geräten wird nun im allgemeinen eine lange Batterielebensdauer angestrebt. Außerdem sollen die Batterien geringes Gewicht und kleine Abmessungen aufweisen, um eine kompakte Bauform der Geräte zu gewährleisten. Dazu ist es notwendig, zum einen den Leistungsverbrauch zu verringern und/oder zum anderen die Anzahl der einzelnen Batteriezellen zu minimieren, was eine kleinere Mindestversorgungsspannung der Empfangsschaltung fordert.

Der sich dadurch ergebende Nachteil ist, daß die Schaltungsanordnung abhängig von Schwankungen der Versorgungsspannung wird.

Aufgabe der Erfindung ist es daher die bekannte Schaltungsanordnung zur Signalbegrenzung und Feldstärkedetektion derart weiterzubilden, daß eine geringere Abhängigkeit von Schwankungen der Versorgungsspannung gewährt wird.

Diese Aufgabe wird bei einer Schaltungsanordnung der eingangs genannten Art dadurch gelöst, daß eine Anordnung zur Kompensation der Schwankung der Stromspeisung vorgesehen ist, die die Differenz eines ersten early-abhängigen Stroms und eines zweiten weniger early-abhängigen Stroms bildet und mit einem Faktor multipliziert und auf den Ausgangsstrom der Stromspeisung aufaddiert.

Der Faktor kann dabei vorteilhafterweise so eingestellt werden, daß der lineare Versorgungsspannungs-Abhängigkeitsterm genau kompensiert wird oder die versorgungsspannungsabhängige Schwankungsbreite minimiert wird.

Die Erfindung wird nachfolgend anhand von 6 Figuren näher erläutert. Es zeigen:
- Figur 1: ein Prinzipschaltbild der erfindungsgemaßen Anordnung,
- Figur 2: ein Ausführungsbeispiel einer kaskadierbaren Begrenzerstufe,
- Figur 3: ein Ausführungsbeispiel einer Referenzspannungsquelle,
- Figur 4: ein Ausführungsbeispiel einer Detektorstufe,
- Figur 5: ein erstes Ausführungsbeispiel einer Kompensationsstufe und
- Figur 6: ein zweites Ausführungsbeispiel einer Kompensationsstufe.

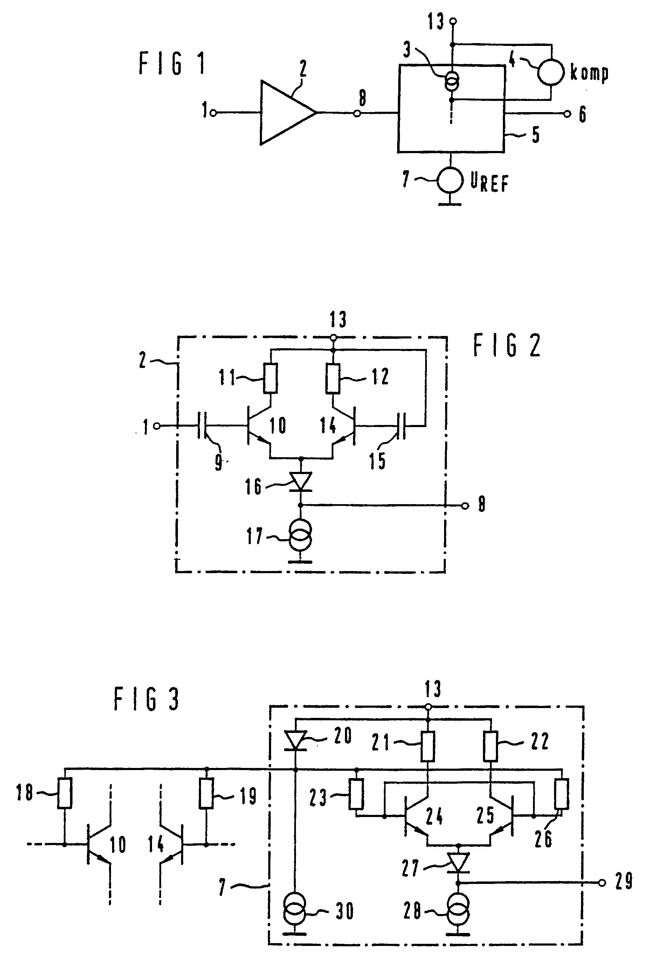

In Figur 1 ist mit 1 eine Eingangsklemme dargestellt, der das HF-Signal zugeführt wird, mit 2 ist eine Begrenzerstufe dargestellt, an derem Ausgang 8 das begrenzte Signal abgreifbar ist. Diese Klemme 8 ist mit dem Eingang einer Detektorstufe 5 verschaltet, welche über eine Versorgungsspannungsklemme 13 und eine an ihr angeschlossene Stromquelle 3 gespeist wird. Das Ausgangssignal der Detektorstufe ist an einer Klemme 6 abgreifbar. Des weiteren wird der Detektorstufe 5 eine Referenzspannung 7 zugeführt. Schließlich ist eine Anordnung 4 zur Erzeugung eines Kompensationsstroms I_{KOMP} vorgesehen, die zwischen Versorgungsspannungsklemme 13 und Ausgang der Stromquelle 3 geschaltet ist.

Die in Figur 1 mit 2 bezeichnete Begrenzerstufe wird nachfolgend in Figur 2 näher erläutert. Bei dem hier gezeigten Ausführungsbeispiel besteht die Begrenzerverstärkerstufe aus zwei npn-Transistoren 10, 14, deren miteinander gekoppelte Emitter über eine Diode 16 und eine Stromquelle 17 mit einem Bezugspotential verbunden sind. Die Kollektoren der beiden Transistoren 10, 14 sind über jeweils einen als Last wirkenden Widerstand 11, 12 an ein Versorgungspotential 13 angeschlossen.

Den Basen der Transistoren 10 und 14 sind jeweils Kapazitäten 9 und 15 vorgeschaltet. Diese können z.B. durch npn-Transistoren, deren Kollektor und Emitter miteinander verschaltet sind, gebildet werden. Die Basen der Transistoren 10 und 14 können dann über die Kapazitäten 9 und 15 über ein differenzielles Eingangssignal angesteuert werden. Im dargestellten Beispiel wird jedoch die Stufe mit einem unsymmetrischen Signal beschaltet, wodurch der erste Eingangsanschluß an der Kapazität 9 mit einer Eingangsklemme 1 verbunden ist und der zweite Eingangsschluß an der Kapazität 15 mit der Versorgungsspannung verbunden ist. Zwischen der Diode 16 und der Stromquelle 17 ist ein Abgriff vorgesehen, der mit einer Ausgangsklemme 8 verschaltet ist. Der Begrenzer ist derat ausgebildet, durch Dimensionierung der Stromquelle 17 und der Widerstände 11 und 12, daß ab einer bestimmten Stärke des Eingangssignals an der Klemme 1 das Ausgangssignal an der Ausgangsklemme 8 im wesentlichen nicht mehr ansteigt.

In Figur 3 ist eine Referenzspannungsquelle dargestellt zur Erzeugung einer Referenzspannung für die Detektorstufe 5. Die Anordnung weist hierzu einen Abgriff des Eingangssignals der Begrenzerstufe an den Basen der Transistoren 10 und 14 über jeweils einen Widerstand 18 und 19 auf. Die jeweils zweiten Anschlüsse der Widerstände sind miteinander verbunden und führen zum jeweils ersten Anschluß eines dritten und vierten Widerstands 23 und 26. Der Widerstand 23 ist zum einen mit dem Basisanschluß eines npn-Transistors 24 und zum anderen mit dem Basisanschluß eines npn-Transistors 25 sowie dem zweiten Anschluß des Widerstands 26 verbunden. Die Emitter der npn-Transistoren 24 und 25 sind ebenfalls miteinander verbunden und über eine Diode 27 und eine Stromquelle 28 mit dem Bezugspotential verschaltet. Die Kollektoren der Transistoren 24 und 25 sind jeweils über einen Widerstand 21 bzw. 22 mit dem Versorgungspotential 13 verschaltet. Des weiteren ist eine Diode 20 vorgesehen, die in Flußrichtung zwischen Versorgungsspannungsklemme 13 und den jeweils ersten Anschlüssen der Widerstände 23 und 26 geschaltet. Schließlich ist zwischen den jeweils ersten Anschlüssen der Widerstände 23 und 26 und dem Bezugspotential eine weitere Stromquelle 30 vorgesehen. Zwischen der Diode 27 und der Stromquelle 28 ist ein Abgriff vorgesehen, der mit einer Ausgangsklemme 29 verbunden ist, an welcher die Referenzspannung abgegriffen werden kann.

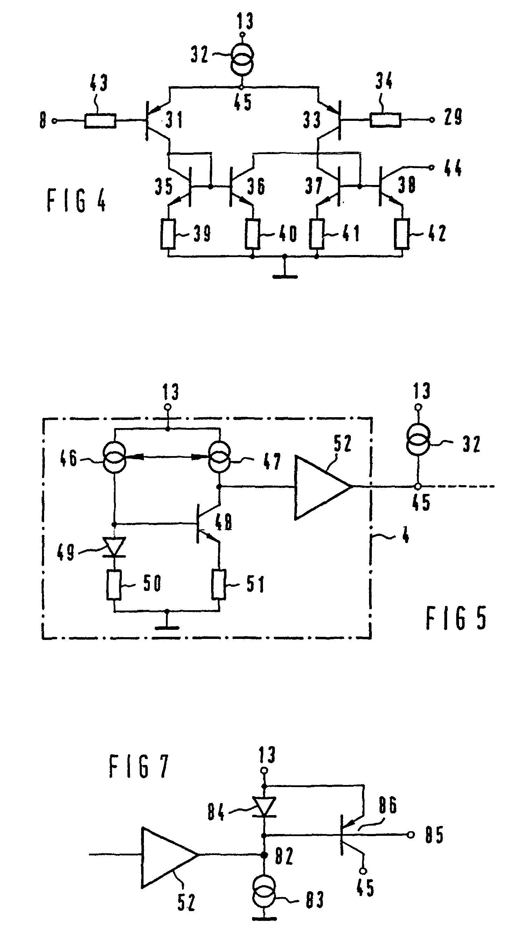

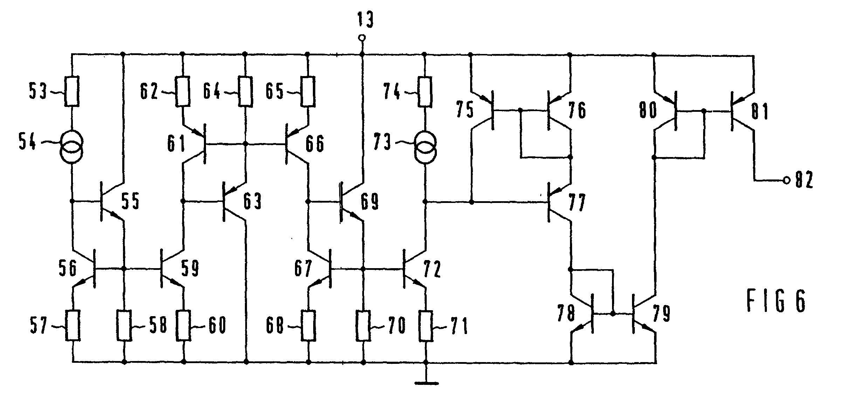

Figur 4 zeigt die Feldstärkedetektorstufe, welche zwei Transistoren vom zu den Transistoren 10 und 14 der Begrenzerverstärkerstufe 2 entgegengesetzten Leitungstyp aufweist, nämlich die pnp-Transistoren 31 und 33. Deren Emitter sind miteinander gekoppelt und über eine Stromquelle 32 an das Versorgungspotential 13 angeschlossen. Die Basis des Transistors 31 ist über einen Widerstand 43 mit den gekoppelten Emittern der Transistoren 10 und 14 über die Eingangsklemme 8 verbunden, während die Basis des Transistors 33 über einen Widerstand 34 mit der Ausgangsklemme 29 der Referenzspannungsquelle 7 verbunden ist. Die Kollektoren der Transistoren 31 und 33 sind über jeweils den Eingangskreis eines Stromspiegels an das Bezugspotential gelegt. Dazu ist der Kollektor des Transistors 31 über einen durch Verbinden von Basis und Kollektor zu einer Diode in Durchlaßrichtung verschalteten npn-Transistor 35 und einen in die Emitterleitung des Transistors 35 geschalteten Widerstand 39 an das Bezugspotential angeschlossen. Basis und Kollektor des Transistors 35 sind mit der Basis eines npn-Transistors 36 verschaltet, dessen Emitter über einen Widerstand 40 ebenfalls mit dem Bezugspotential verbunden ist. Entsprechend ist auch der Kollektor des Transistors 33 über einen durch Verbinden von Basis und Kollektor als Diode in Durchlaßrichtung betriebenen npn-Transistors 37 und einen in die Emitterleitung des Transistors 37 geschalteten Widerstand 41 mit dem Bezugspotential gekoppelt. An Basis und Kollektor des Transistors 37 ist demgemäß die Basis eines npn-Transistors 38 angeschlossen, dessen Emitter über einen Widerstand 42 mit dem Bezugspotential verbunden ist und dessen Kollektor ein Ausgangssignal 44 führt. Zudem ist der Ausgangskreis des Stromspiegels mit den Transistoren 35 und 36 sowie den Widerständen 39 und 40 mit dem Eingangskreis des Stromspiegels mit den Transistoren 37 und 38 sowie den Widerständen 41 und 42 gekoppelt. Dazu ist der Kollektor des Transistors 36 mit den Basen der Transistoren 37 und 38 verbunden.

Bei einer derartigen Schaltungsanordnung sind die Differenzverstärker bei Feldstärkedetektorstufe und Begrenzerverstärkerstufe mit Transistoren vom gegensätzlichen Leitungstyp ausgebildet. Daraus ergibt sich, daß die gekoppelten Emitter der Transistoren 10 und 14 über die gemeinsame Stromquelle 3 auf Bezugspotential gelegt sind, während die gekoppelten Emitter der Transistoren 31 und 33 über die gemeinsame Stromquelle 32 an das Versorgungspotential 13 angeschlossen sind.

Folglich sind auch die jeweiligen Lasten mit unterschiedlichen Potentialen verbunden. Es sind demnach die Widerstände 11 und 12 zwischen die Kollektoren der Transistoren 10 und 14 und das Versorgungspotential 13 geschaltet, während die Eingangskreise der beiden Stromspiegel, gebildet durch die Transistoren 35 bzw. 37 und die Widerstände 39 bzw. 41, zwischen die Kollektoren der Transistoren 31 und 33 und das Bezugspotential geschaltet sind. Daraus ergibt sich für die Schaltungsanordnung, daß das Eingangssignal der Feldstärkedetektorstufe, nämlich die Differenz zwischen dem Potential an der Basis des Transistors 31 und dem Bezugspotential, lediglich eine durch den zu einer Diode verschalteten Transistor 35 vorgegebene Diodenschwelle zu überwinden braucht.

Des weiteren wird der mit dem Eingangssignal beaufschlagte Transistor 31 nur mit dem Eingangskreis eines Stromspiegels belastet, was in etwa einer Diodenschwelle gleich kommt, während der mit dem Referenzpotential 29 angesteuerte Transistor 33 sowohl mit dem Ausgangskreis des einen Stromspiegels als auch mit dem Eingangskreis des anderen Stromspiegels belastet wird, was einen höheren Spannungsabfall an dieser Stelle zur Folge hat. Der Ausgangskreis des anderen Stromspiegels mit dem Transistor 38 und dem Widerstand 42 bildet eine Stromsenke. Bei der Kaskadierung können diese Stromsenken von mehreren Detektorstufen parallel geschaltet werden. Mittels z.B. eines nachgeschalteten zusätzlichen Stromspiegels läßt sich dann auf einfache Weise auch ein Stromquellenbetrieb herstellen.

Wie aus Figur 4 zu entnehmen ist, wird insbesondere durch die direkt mit der Versorgungsspannungsklemme 13 verbundene Stromquelle 32 eine relativ starke Abhängigkeit der Stromspeisung von der Versorgungsspannung bewirkt. In Figur 4 ist der Knotenpunkt der Emitter der Transistoren 31 und 33 sowie der Stromquelle 32 mit 45 bezeichnet. Erfindungsgemäß wird nun dieser Punkt 45 mit einem Kompensationsstrom beaufschlaget, um die Stromspeisung der Detektorstufe unabhängig von Schwankungen der Versorgungsspannung zu machen.

Hierzu zeigt Figur 5 eine erste Ausführungsform einer erfindungsgemäßen Stufe zur Bereitstellung eines Kompensationsstroms. Diese besteht aus zwei gekoppelten Stromquellen 46 und 47, die eingangsseitig mit der Versorgungsklemme 13 verbunden sind. Die Kopplung ist durch einen Pfeil angedeutet, die Stromquellen 46 und 57 sind ausgangsseitig mit dem Eingangs- bzwl. Ausgangskreis eines Stromspiegels verbunden. Hierzu ist der Ausgang der Stromquelle 46 über eine Diode 49 und einen in Reihe geschalteten Widerstand 50 mit dem Bezugspotential verbunden. Des weiteren ist der Ausgang der Stromquelle 46 mit dem Basisanschluß eines npn-Transistors 48 verschaltet. Der Ausgangsanschluß der Stromquelle 47 ist zum einen mit einem Stromverstärker 52, der als I/I-Verstärker ausgebildet ist, und zum anderen mit dem Kollektor des npn-Transisstors verbunden. Dessen Emitter ist über einen Widerstand 51 mit dem Bezugspotential verschaltet. Am Ausgang des Stromverstärkers 52 ist der gewonnene Kompensationsstrom mit wählbarem Faktor (Kompensationsfaktor) abgreifbar, der dem Knotenpunkt 45 zugeführt wird.

Alternativ kann dem Stromverstärker 52 auch eine Anordnung gemäß Figur 7 nachgeschaltet werden. Hier ist ein Stromspiegel vorgesehen, der aus der Stromquelle 83 und einer in Reihe geschalteten Diode 84 sowie einem pnp-Transistor 86 besteht. Die Diode 84 ist in Flußrichtung und in Reihe mit der Stromquelle 83 zwischen Versorgungsspannungsklemme 13 und Masse geschaltet. Der Knotenpunkt 82 der Reihenschaltung ist zum einen mit dem Ausgang des Verstärkers 52 und zum anderen mit der Basis des Transistors 86 verbunden die wieder an eine Klemme 85 angeschlossen ist und z.B. an eine Strombank zur Versorgung mehrerer kaskadierter Begrenzer/Detektorstufen mit gleichen Stromquellen gekoppelt ist. Der Kollektor des Transistors 86 bildet dann den Kollektor-Ausgang 45 und der Emitter des Transistors 86 ist mit der Versorgungsspannungsklemme 13 verbunden.

Das versorgungsspannungsabhängige Problem wirkt sich im Detail so aus, daß der Ausgangsstrom an der Klemme 44 der Detektorstufe mit steigender Versorgungsspannung steigt. Ursache hierfür ist in erster Linie die Early-Spannungsabhängigkeit aller Kollektorströme der Transistoren 31, 33, 35, 37, die sich direkt auf den Ausgangsstrom an der Klemme 44 auswirkt, sowie die Early-Spannungsabhängigkeit des Kollektorstroms der Stromquelle 17, die sich auf die Verstärkung pro kaskadierter Begrenzerstufe auswirkt. Mit steigender Verstärkung pro Stufe steigt auch die Steilheit der Feldstärke-Detektor-Kennlinie an wodurch der spannungsabhängige Effekt und damit die Ungenauigkeit des Meßergebnisses verstärkt wird. Der Kompensationsstrom I_{KOMP} wird aus der Differenz eines ersten early-abhängigen Stroms der Stromquelle 46 und eines weniger early-abhängigen Stroms der Stromquelle 47 gebildet und mit einem Faktor multipliziert, welcher durch die Pufferstufe 52 in Figur 5 gegeben ist. Dabei wird die Dimensionierung so gewählt, daß eine lineare Abhängigkeit des Ergebnisses an der Klemme 44 erzielt wird und die Abhängigkeit somit unabhängig von der Versorgungsspannung wird.

Die beiden gekoppelten Stromquellen liefern theoretisch gleich große Ströme. Durch ihren jedoch endlichen definierten Innenwiderstand und die unterschiedliche Belastung im jeweiligen Ausgangskreis liegen unterschiedliche early-Abhängigkeiten vor.

Figur 6 zeigt hierzu ein weiteres ausführlicheres Ausführungsbeispiel einer erfindungsgemäßen Anordnung zur Bereitstellung eines Kompensationsstroms. Die erste Stromquelle ist mit 54 bezeichnet und ist eingangsseitig über einen Widerstand 53 mit der Versorgungsspannungsklemme 13 verbunden. Ausgangsseitig ist die Stromquelle 54 zum einen mit dem Basisanschluß eines npn-Transistors 55 und dem Kollektor eines npn-Transistors 56 verbunden. Der Emitter des Transistors 56 ist über einen Widerstand 57 mit dem Bezugspotential verschaltet. Der Emitter des Transistors 55 ist zum einen mit dem Basisanschluß des Transistors 56 sowie über einen Widerstand 58 mit dem Bezugspotential und mit dem Basisanschluß eines weiteren npn-Transistors 59 verschaltet. Dessen Emitter ist ebenfalls über einen Widerstand 60 mit Bezugspotential verbunden. Der Kollektor des Transistors 59 ist zum einen mit dem Basisanschluß eines pnp-Transistors 63 und dem Kollektoranschluß eines pnp-Transistors 61 verschaltet. Der Emitter des pnp-Transistors 61 ist über einen Widerstand 62 mit der Versorgungsspannungsklemme 13 verschaltet. Der Basisanschluß des Transistors 61 ist mit dem Emitter des Transistors 63 sowie mit dem Basisanschluß eines weiteren pnp-Transistors 66 und über einen Widerstand 64 mit der Versorgungsspannungsklemme 13 verschaltet. Der Emitter des Transistors 66 ist über einen Widerstand 65 mit der Versorgungsspannungsklemme verbunden. Der Kollektor des Transistors 66 ist zum einen mit dem Basisanschluß eines npn-Transistors 69 und dem Kollektoranschluß eines npn-Transistors 67 verbunden. Die Emitter der Transistoren 67 und 69 sind jeweils über Widerstände 68 und 70 mit dem Bezugspotential verschaltet. Des weiteren ist der Basisanschlulß des Transistors 67 mit dem Emitteranschluß des Transistors 69 und dem Basisanschluß eines weiteren npn-Transistors 72 verbunden. Der Emitter des Transistors 72 ist ebenfalls über einen Widerstand 71 mit dem Bezugspotential verschaltet. Der Kollektor ist über die zweite Stromquelle 73 und einen in Reihe geschalteten Widerstand 74 mit dem Versorgungsspannungsanschluß 13 verbunden. Des weiteren ist der Kollektor des Transistors 72 zum einen mit dem Kollektor eines weiteren pnp-Transistors 75 und dem Basisanschluß eines weiteren pnp-Transistors 77 verschaltet. Der Basisanschluß des Transistors 75 ist zum einen mit dem Basisanschluß eines als Diode geschalteten pnp-Transistors 76 verbunden, dessen Kollektor mit der Basis verbunden ist, und zum anderen mit dem Emitter des Transistors 77. Die Emitter der Transistoren 75 und 76 sind mit der Versorgungsspannungsklemme verschaltet. Der Kollektor des Transistors 77 ist mit dem Kollektor eines als Diode geschalteten npn-Transistors 78, dessen Kollektor und Basis miteinander verbunden sind, verschaltet. Die Basis des Transistors 78 ist mit der Basis eines npn-Transistors 79 verschaltet. Die Emitter der Transistoren 78 und 79 sind mit dem Bezugspotential verbunden. Der Kollektor des Transistors 79 ist mit dem Kollektor eines als Diode geschalteten pnp-Transistors 80, dessen Kollektor und Basis miteinander gekoppelt sind, verbunden. Die Basisanschlüsse des Transistors 80 und eines weiteren pnp-Transistors 81 sind miteinander verbunden und die Emitteranschlüsse der Transistoren 80 und 81 sind mit der Versorgungsspannungsklemme 13 verschaltet. Der Kollektor des Transistors 81 ist mit einer Ausgangsklemme 82 verbunden, die dem Knotenpunkt 82 aus Figur 7 entsprechen kann.

Wie zu sehen ist, wird der Strom der Stromquelle 54 über drei Stromspiegel, gebildet aus den Transistoren 55, 56, 59 sowie 61, 63, 66 und 67, 69, 72 und den zugehörigen Widerständen, vom Strom der Stromquelle 73 abgezogen. Der so erhaltene Strom wird wiederum über drei Stromspiegel 75 bis 81 ausgekoppelt, wobei der Stromspiegel bestehend aus den Transistoren 78 und 79 den Kompensationsstrom mit dem oben erwähnten Faktor multipliziert. Hierbei kann der Ausgangstransistor 79 durch mehrere parallel geschaltete Transistoren vom gleichen Typ entsprechend dimensioniert werden.

Der Stromspiegel 75...81 dient der Einstellung des Kompensationsfaktors, z.B. auch durch parallelgeschalteten mehrerer Transistoren oder Verwendung von Transistoren mit verschiedenen Emitterflächen. Stromspiegel 75...77 ist hier als Wilson-Stromspiegel ausgebildet und hat einen Stromverstärkungsfaktor 1 mit β-Basisstromkompensation zur Spiegelung eines sehr kleinen Stromes mit kleinem Faktor.

## Patentansprüche

1. Bipolare kaskadierbare Schaltungsanordnung mit einer Begrenzerstufe (2), die ein Ausgangssignal erzeugt, das einer Detektionsstufe (5) zugeführt wird, wobei die Detektionsstufe (5) stromgespeist wird und diese Stromspeisung (3) und damit das Ausgangssignal der Detektionsstufe (5) abhängig von der Versorgungsspannung (13) ist,
**dadurch gekennzeichnet, daß** eine Anordnung zur Kompensation (4) der Schwankungen der Stromspeisung (3) vorgesehen ist, die die Differenz eines ersten early-abhängigen Stroms und eines zweiten weniger early-abhängigen Stroms bildet und mit einem Faktor multipliziert und auf den Ausgangsstrom der Stromspeisung aufaddiert.

2. Schaltungsanordnung nach Anspruch 1,
**dadurch gekennzeichnet, daß** zwei gekoppelte Stromquellen (46, 47) zur Bildung des ersten early-abhängigen Stroms und des zweiten weniger early-abhängigen Stroms vorgesehen sind, die eingangsseitig mit der Versorgungsspannungsklemme (13) und ausgangsseitig zum einen mit dem Eingangskreis und zum anderen mit dem Ausgangskreis eines Stromspiegels (48, 49) verbunden sind, daß der Knotenpunkt des Ausgangskreises des Stromspiegels und des Ausgangs der zweiten Stromquelle mit dem Eingang einer Stromverstärkerstufe (52) verbunden sind, deren Ausgang den Kompensationsstrom bereitstellt.

3. Schaltungsanordnung nach einem der vorhergehenden Ansprüche,
**dadurch gekennzeichnet, daß** der Ausgangsstrom einer ersten Stromquelle (54) über wenigstens einen Stromspiegel (55...60;61...66;67...72) ausgekoppelt wird und vom Ausgangsstrom einer zweiten Stromquelle (75...77;78...79;80...81) abgezogen wird und der so erhaltene Strom über wenigstens eine weitere Stromquelle ausgekoppelt wird und auf den Ausgangsstrom der Stromspeisung aufaddiert wird.

4. Schaltungsanordnung nach Anspruch 2,
**dadurch gekennzeichnet, daß** der Ausgangsstrom des Verstärkers (52) einem weiteren Stromspiegel (83, 84, 86) zugeführt wird, an dessen Ausgang der kompensierte Strom abgreifbar ist.

5. Schaltungsanordnung nach Anspruch 4,
**dadurch gekennzeichnet, daß** der Transistor (8b) des Stromspiegels Basis einer Strombank zur Versorgung mehrerer kaskadierter Begrenzer/Detektionsstufen ist.

## Claims

1. Bipolar circuit arrangement, which can be cascaded, having a limiter stage (2) which produces an output signal which is supplied to a detection stage (5), with the detection stage (5) being current-fed and this current feed (3) and hence the output signal from the detection stage (5) being dependent on the supply voltage (13),
**characterized in that** an arrangement for compensation (4) for fluctuations in the current feed (3) is provided, which forms the difference between a first early-dependent current and a second less early-dependent current, multiplies this by a factor, and adds it to the output current from the current feed.

2. Circuit arrangement according to Claim 1,
**characterized in that** two coupled current sources (46, 47) are provided in order to form the first early-dependent current and the second less early-dependent current, and are connected on the input side to the supply voltage terminal (13) and on the output side firstly to the input circuit and secondly to the output circuit of a current mirror (48, 49), in such a way that the node point of the output circuit of the current mirror and of the output of the second current source are connected to the input of a current amplifier stage (52), whose output provides the compensation current.

3. Circuit arrangement according to one of the preceding claims,
**characterized in that** the output current from a first current source (54) is output via at least one current mirror (55...60; 61...66; 67...72) and is subtracted from the output current from a second current source (75...77; 78...79; 80...81), and the current obtained in this way is output via at least one further current source and is added to the output current from the current feed.

4. Circuit arrangement according to Claim 2,
**characterized in that** the output current from the amplifier (52) is supplied to a further current mirror (83, 84, 86), at whose output the compensator current can be tapped off.

5. Circuit arrangement according to Claim 4,
**characterized in that** the transistor (8b) of the current mirror is the base of an electrical power supply for supplying a number of cascaded limiter/detection stages.

## Revendications

1. Circuit cascadable bipolaire comprenant un étage limiteur (2) qui produit un signal de sortie qui est envoyé à un étage détecteur (5), l'étage détecteur (5) étant alimenté en courant et cette alimentation en courant (3) et donc le signal de sortie de l'étage détecteur (5) étant dépendants de la tension d'alimentation (13),
**caractérisé par le fait qu'**il est prévu pour la compensation (4) des variations de l'alimentation en courant (3) un dispositif qui forme la différence d'un premier courant dépendant de Early et d'un deuxième courant moins dépendant de Early, qui la multiplie par un facteur et qui l'ajoute au courant de sortie de l'alimentation en courant.

2. Circuit selon la revendication 1,
**caractérisé par le fait qu'**il est prévu pour la formation du premier courant dépendant de Early et du deuxième courant moins dépendant de Early deux sources de courant couplées (46, 47) qui sont reliées en entrée à la borne de tension d'alimentation (13) et en sortie d'une part au circuit d'entrée et d'autre part au circuit de sortie d'un miroir de courant (48, 49) et que le point de jonction du circuit de sortie du miroir de courant et de la sortie de la deuxième source de courant est relié à l'entrée d'un étage amplificateur de courant (52) dont la sortie fournit le courant de compensation.

3. Circuit selon l'une des revendications précédentes,
**caractérisé par le fait que** le courant de sortie d'une première source de courant (54) est découplé par l'intermédiaire d'au moins un miroir de courant (55 à 60 ; 61 à 66 ; 67 à 72) et est soustrait du courant de sortie d'une deuxième source de courant (75 à 77 ; 78 à 79 ; 80 à 81) et que le courant ainsi obtenu est découplé par l'intermédiaire d'au moins une autre source de courant et est ajouté au courant de sortie de l'alimentation en courant.

4. Circuit selon la revendication 2,
**caractérisé par le fait que** le courant de sortie de l'amplificateur (52) est envoyé à un autre miroir de courant (83, 84, 86) à la sortie duquel le courant compensé peut être prélevé.

5. Circuit selon la revendication 4,
**caractérisé par le fait que** le transistor (8b) du miroir de courant est à la base d'un banc de courant pour l'alimentation de plusieurs étages limiteurs/détecteurs mis en cascade.
